# EUROPÄISCHE PATENTSCHRIFT

(11) **EP 0 242 682 B1**
(45) Veröffentlichungstag und Bekanntmachung des Hinweises auf die Patenterteilung: **10.03.1993**
(21) Anmeldenummer: 87105041.5
(22) Anmeldetag: 04.04.1987
(51) Int. Cl.: H05K 7/12, H05K 7/02

(54) **Befestigungseinrichtung für elektrische Bauelemente auf einer Trägerplatte**
Device for mounting electrical components on a supporting plate
Dispositif pour la fixation de composants électriques sur une plaque-support

(30) Priorität: 24.04.1986 DE 3613863
(43) Veröffentlichungstag der Anmeldung: 28.10.1987
(73) Patentinhaber: BSG-Schalttechnik GmbH & Co. KG, D-72336 Balingen (DE)
(72) Erfinder: Geiger Peter, D-7460 Balingen (DE)
(74) Vertreter: Otte, Peter, Dipl.-Ing.

(56) Entgegenhaltungen:
- DE-A- 2 714 168
- DE-A- 3 006 673

## Beschreibung

### Stand der Technik

Die Erfindung geht aus von einer Befestigungsanordnung nach dem Oberbegriff des Anspruchs 1.

Bei einer bekannten Befestigungsanordnung dieser Art (DE-A-3 006 673) wird zur Verbindung eines Blechteils mit einem anderen Bauteil, welches speziell eine gedruckte Leiterplatte sein kann, so vorgegangen, daß ein von dem Blechteil vorstehender unten hakenartig ausgebildeter Ansatz durch einen plastisch verformbaren Steg mit dem Blechteil verbunden ist und durch Einführen beispielsweise eines Schraubendrehers in einen Schlitz am Blechteil der Steg so bleibend verformt wird, daß der Haken am Ansatz die Leiterplatte hintergreift. Ein von dem Blechteil vorstehender, feststehender Anschlag in der Ausnehmung der Leiterplatte verhindert eine Verschiebung des Blechteiles gegenüber der Leiterplatte. Hierbei kann sich das Blechteil selbst mit weiteren Flächen von oben an der Leiterplatte abstützen.

Ein anderes Befestigungsmittel zur Anordnung von Bauelementen, die beispielsweise eine Leuchtanzeige und Schaltmittel sein können (DE-A-2 714 168), auf einer Leiterplatte besteht darin, daß einander gegenüberliegende, zueinander abgekehrte Hakenvorsprünge aufweisende Rastbeine vorgesehen sind, die einen gemeinsamen Schlitz beispielsweise einer Leiterplatte hintergreifen, wobei ferner Stützstege am Bauelement angeordnet sind, die nach unten bis zur Oberfläche der Leiterplatte reichen.

Allgemein ist es bekannt, elektrische oder elektronische Bauelemente oder Komponenten entweder unmittelbar, wenn sie nämlich hinreichend klein sind, also geringe Abmessungen aufweisen, mit ihren elektrischen Anschlüssen auf Trägerplatten, Printplatten, Leiterplatten u. dgl. zu befestigen, beispielsweise Chips, Widerstände, kleinere Kondensatoren u. dgl. oder bei größeren Bauelementen auch an dessen Gehäuse, soweit vorgesehen, Rastnasen tragende Verlängerungen anzuordnen und ein solches Bauelement dann in Ausnehmungen der Trägerplatte einzuklipsen und zu verrasten.

Bei einer solchen Befestigungsart durch Eindrücken von zurückspringenden Rastnasen, die dann die Trägerplattenrückseite wieder hintergreifen, können sich Probleme ergeben, beispielsweise dann, wenn das zu befestigende Bauteil relativ schwer oder groß ist, grundsätzlich aber auch dann, wenn ein mit einer solchen Trägerplatte ausgerüstetes Gerät beim Betrieb Bewegungen unterworfen wird oder Schwingungen oder Vibrationen aufzunehmen sind, was bei vielen Geräten, beispielsweise Autoradios, Waschmaschinen oder Spülmaschinen, auch stationären Elektrogeräten oder Elektrohandgeräten der Fall ist.

Die folgende Erläuterung bezieht sich aus Klarheitsgründen speziell auf die Befestigung einer Funkentstördrossel auf einer Printplatte; es versteht sich aber, daß die Erfindung nicht in ihrer Anwendung auf eine Funkentstördrossel beschränkt ist, sondern allgemein der Befestigung von beliebigen elektronischen und elektrischen Bauelementen und Komponenten auf einer Trägerplatte dienen kann, insbesondere großer und schwerer Bauelemente wie Trafos, Kondensatoren, Relais, Stecker u. dgl.

Bisher mußten Funkentstördrosseln oder auch Stromdämpfungsdrosseln, gegebenenfalls beide Drosseln gemeinsam kombiniert mit unterschiedlichen Kernen, nämlich einem Ferritkern und einem Eisenpulverkern, so auf Trägerplatten befestigt werden, daß zunächst die jeweiligen Kerne, etwa durch ein Tauchverfahren, mit einer isolierenden Kunststoffschicht oder einer sonstigen Schicht überzogen wurden, und anschließend wurden auf diese eine Ringform aufweisenden Kerne üblicherweise von Wickelautomaten die elektrischen Wicklungen aufgebracht. Die weiteren Befestigungs- und Verarbeitungsschritte bestanden dann darin, daß eine solchermaßen aufgebaute Drossel in einen Kunststoffbecher eingeführt und dann vergossen worden ist, woraufhin dann der Becher in geeigneter Weise, üblicherweise mit Hilfe von Schrauben auf der Trägerplatte befestigt wird. Dies ist in mehrfacher Hinsicht nachteilig, weil schon durch die mechanische Bewicklung mit Automaten die Gefahr besteht, daß die Kunststoffisolierschicht auf den Drosselkernen verletzt wird und hierdurch Kurzschlüsse zwischen Windungsteilen auftreten; aber auch durch das Verschrauben der vergossenen, die Ferrit- oder Eisenpulverkerne enthaltenden Kunststoffbecher ergab sich nicht selten eine Beschädigung der empfindlichen Ringkerne, indem diese etwa durch das feste Anziehen der Befestigungsschrauben zerbrachen, wodurch die Drossel ihre Wirkung verliert.

Andererseits kann man eine solche Drossel nicht einfach an ihren Befestigungsdrähten in der Trägerplatte aufhängen, da schon allein durch das Kernmaterial ein erhebliches Gewicht vorhanden ist, was, etwa bei Vibrationen oder auch bei Schlag- oder Simulationsprüfungen für einen Transporttest u. dgl. zu einem schnellen Ablösen oder einer Verlagerung eines solchen Bauelementes auf der Trägerplatte führt. Tatsächlich ergeben sich bei bestimmten Transporttesten dieser Art, wie sie beispielsweise für Waschmaschinen, Spülmaschinen o. dgl. durchgeführt werden müssen, um überprüfen zu können, daß entsprechende Bauelemente auf den elektrischen bzw. elektronischen Schaltungsbereichen auch hinreichend festsitzen, unter Umständen örtliche Beschleunigungseinwirkungen bis zu 70 g - Krafteinwirkungen also, die in Verbindung mit der Masse bzw. dem Gewicht der auf den Trägerplatten zu befestigenden Bauelemente an die Befestigungsart erhebliche Ansprüche stellen.

Der Erfindung liegt daher die Aufgabe zugrunde, eine Befestigungsanordnung der eingangs genannten Art so zu verbessern, daß einmal ein schnelles und problemloses Befestigen beliebiger Bauelemente auf einer zugeordneten Trägerplatte, insbesondere Printplatte möglich ist, wobei vorzugsweise gleichzeitig auch Mittel zur Herstellung der elektrischen Verbindungen vorgesehen sind, und die andererseits sicherstellt, daß auch bei erheblichen, einwirkenden Belastungen eine einwandfreie und sichere Lagerung auf der Printplatte gewährleistet ist.

### Vorteile der Erfindung

Diese Aufgabe wird mit den Merkmalen des Anspruchs 1 gelöst, wobei sich der Vorteil ergibt, daß bei besonders einfacher Lagerung und Aufnahme der elektrischen Bauelemente eine gleichfalls einfache, durch einen Einrastvorgang mit nachfolgender Verriegelung und Fixierung bewirkte Befestigung des Bauelements (mit seinem Trägerteil) auf der Printplatte möglich ist, und durch den gleichen Einklips-Arbeitsgang aufgrund der speziellen Struktur und des Aufbaus der Verrastungsmittel gleichzeitig eine feste seitliche und Höhen-Fixierung und der sichere Sitz in der Printplatte erreicht wird.

Unter Verzicht auf die üblichen, insbesondere bei schwereren elektrischen Bauelementen erforderlichen Verschraubungen oder sonstigen, umständliche Montagevorgänge erforderlichen Befestigungsarten sichert die Erfindung das gleichzeitige Befestigen und die Positionierung der elektrischen Zuleitungen, wobei das eigentliche elektrische Bauelement sicher in der zugeordneten Halterung aufgenommen ist.

Durch das Einrasten, also das anfängliche Zurückweichen der Rastnasen an den Rastbeinen beim Einklipsen wird jedes Rastbein in seiner Aufnahmeöffnung, also in der es aufnehmenden Trägerplattendurchbrechung sicher verspannt und fixiert. Tatsächlich muß eine solche Trägerplattenöffnung bei üblicher, für sich gesehen bekannter Rastbeinfixierung, bei welcher also an einer Verlängerung eine senkrecht zur Einführungsrichtung vorspringende Rastnase vorhanden ist, mindestens einen Öffnungsquerschnitt aufweisen, der so groß wie der die seitlich vorspringende Rastnase tragende Kopf des jeweiligen Rastbeins ist, so daß nach dem Hintergreifen der Trägerplattenrückfläche notwendigerweise immer ein Abstandsspalt verbleibt, der so groß ist wie der von der Rastnase in Querrichtung gebildete Vorsprung, denn sonst könnte das jeweilige Rastbeinchen durch die entsprechende Aufnahmeöffnung nicht hindurchgeführt werden. Dies bedeutet aber bei der üblichen Rastbeinchenbefestigung, daß das Bauelement notwendigerweise locker in seiner Halterung sitzt, unter Umständen auch dann, wenn mehrere Rastbeinchen mit Rastnasen in unterschiedlichen Richtungen vorhanden sind, so daß durch eine entsprechende Vorspannung mindestens eine Außenanlage nach Hintergreifung, also ein Anschlag der Rastbeinchen unter Vorspannung, möglich ist. Stärkere Einwirkungen auf eine solche Lagerung, wie weiter vorn geschildert, können das Bauelement nämlich schrägziehen und in den verbleibenden Toleranzen der Aufnahmeschlitze verkanten, so daß gegebenenfalls anfangs nur ein oder zwei der vorhandenen Rastbeinchen aushängen,und bei einer einwirkenden Beschleunigung in einer anderen Richtung dann alle Rastbeinchen ihren Halt verlieren, da sie eben in ihren jeweiligen zugeordneten Aufnahmeöffnungen nicht abstandsfrei sitzen können und dann das ganze Bauelement von der Trägerplatte los kommt, so daß sich erhebliche Beschädigungen ergeben können.

Diese Möglichkeit wird dadurch ausgeschlossen, daß angrenzend an jedes Rastbein ein Fixierbein so angeordnet ist, daß dann, wenn das Rastbeinchen nach elastischem Zurückweichen mit der Rastnase die Trägerplatte hintergreift, Rastbein einerseits und Fixierbein andererseits in dem Ausschnitt der Trägerplatte oder Leiterplatte beidseitig, gegebenenfalls unter einer gewissen Vorspannung, anliegen, so daß jeder einzelne Befestigungspunkt für sich schon unverrückbar gesichert und gehalten ist.

Dabei sorgt das Fixierbein durch einen eigenen Höhenanschlag, der in der entsprechenden Abstandsbeziehung zur unteren Randkante der in Querrichtung vorspringenden Rastnase angeordnet ist, für eine spielfreie Höhenfixierung, wobei in weiterer Ausgestaltung auch ein Ausgleich der Dickentoleranz der Trägerplatte möglich ist, indem der Höhenanschlag im Toleranzfeld federnd ausgebildet wird.

Schließlich kann dann noch eine zusätzliche Sicherung der vorzugsweise außenstehenden Rastbeine untereinander gegen ein Zurückweichen erfolgen, indem eine zusätzliche Verriegelungsulatte in eine Aufnahmeöffnung der das Bauelement tragenden Printplatte von der Rückseite eingeklipst wird, derart, daß sich eine unmittelbare Anlage der Fixierscheibe an die Rastbeinrückseitenflächen zur Sicherung von deren unverrückbarer Fixierung ergibt.

Durch die in den Unteransprüchen aufgeführten Maßnahmen sind weitere vorteilhafte Weiterbildungen und Verbesserungen der Befestigungsanordnung möglich. Besonders vorteilhaft ist die zusätzliche Anordnung von Führungskanälen für elektrische Anschlußleitungen im Bereich der Befestigungsmittel oder der Trägerteile für diese, die vorzugsweise bis angrenzend an die Leiterplatte verlaufen, so daß unmittelbar mit dem Einklipsen des elektrischen Bauelements gleichzeitig auch die elektrischen Leitungen in entsprechende Öffnungen der Printplatte zur nachfolgenden elektrischen Kontaktierung mit entsprechenden Leitungsbahnen geführt sind.

### Zeichnung

Ausführungsbeispiele der Erfindung sind in der Zeichnung dargestellt und werden in der nachfolgenden Beschreibung näher erläutert. Es zeigen:
- Fig. 1: eine Draufsicht auf ein elektrisches Bauelement mit Befestigungseinrichtung von unten,
- Fig. 2: eine Seitenansicht des auf der gestrichelt angedeuteten Printplatte angeordneten Bauelements mit seiner Befestigungseinrichtung,
- Fig. 3: eine vergrößerte Teilausschnittdarstellung längs der Linie III-III der Fig. 1 und
- Fig. 4: eine ebenfalls vergrößerte Darstellung der Einzelheit X in Fig. 1, die die Heranführung elektrischer Leitungen an die Trägerplatte betrifft.

### Beschreibung der Ausführungsbeispiele

Die nachfolgende Erläuterung betrifft speziell und aus Gründen der Klarheit ausschließlich die Aufnahme, Halterung und Befestigung einer Drossel, beispielsweise Motordrossel zur Funkentstörung und/oder Stromdämpfung bei elektrischen Geräten auf einer geeigneten Leiter- oder Printplatte, wobei in diesem Fall ferner die Drossel als Ringkerndrossel mit zwei Ringkernen aus verschiedenem Material (Ferritkern, Eisenpulverkern) und beide Kerne umgeben von einer entsprechenden elektrischen Wicklung, ausgebildet ist. Es versteht sich aber und ist weiter vorn schon erwähnt, daß die Erfindung jedes beliebige elektrische Bauelement betrifft bzw. auf ein solches angewendet werden kann, wenn es auf einerTrägerplatte, die insbesondere eine Leiter- oder Printplatte sein kann, zu befestigen ist.

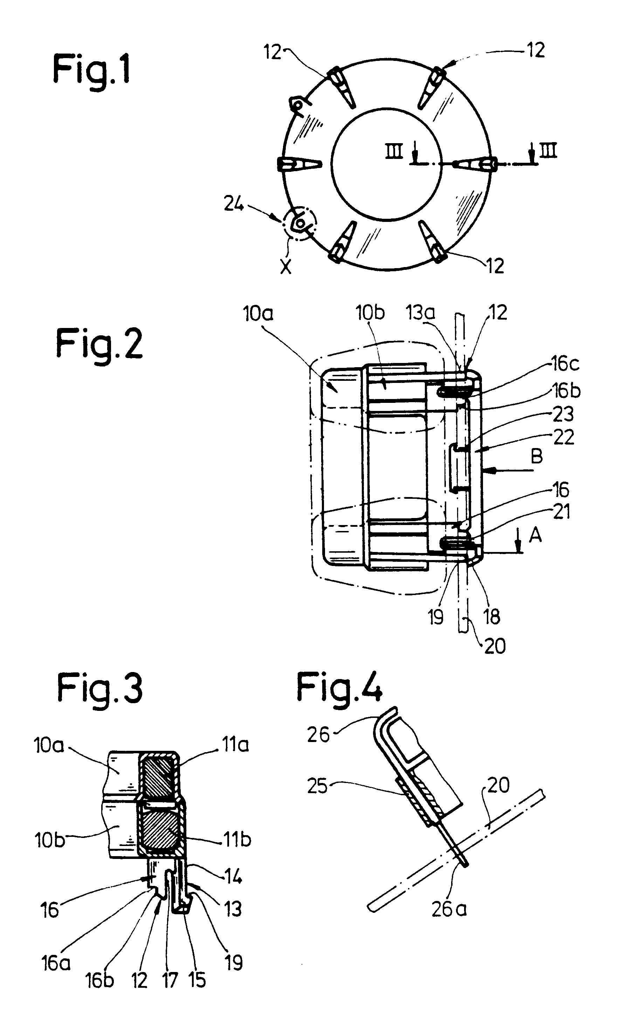

Sind daher im Falle der der Erläuterung dienenden Ringkerndrossel zwei ein Gehäuse für die Drossel bildende ringförmige Halbschalen 10a, 10b vorgesehen, die jeweils einen der Ringkerne 11a, 11b (s. auch Fig. 3) aufnehmen, so kann das Gehäuse, wie es sich versteht, bei anderen Bauelementen auch lediglich eine dieses Bauelement lagernde oder tragende, untere Fläche sein, von welcher dann die den Gegenstand der vorliegenden Erfindung betreffenden, eigentlichen Befestigungs- und Verriegelungsmittel ausgehen, die in der Fig. 2 allgemein mit 12 bezeichnet sind. Daher kann bei anderen Bauelementen, beispielsweise Relais, größere Kondensatorbecher u. dgl. der Zwischenteil, der das eigentliche elektrische Bauelement lagert, auch ein Halbbecher, eine angespritzte untere Fläche o. dgl. sein, vorzugsweise aus Kunststoff, von der dann in Richtung auf die das Ganze lagernde Leiterplatte die Befestigungs- und Verrastungsmittel 12 ausgehen.

Wie am besten der Darstellung der Fig. 3 entnommen werden kann, bestehen diese Verrastungsmittel aus einem ersten, für sich gesehen bekannten Rastbein 13, gebildet aus einer von dem Gehäuse 10a, 10b nach unten wegstehenden Verlängerung oder Steg 14 und einer an diesen in Querrichtung angesetzten Rastnase 15.

Da es sich bei dem hier zu erläuternden elektrischen Bauelement um eine Ringkerndrossel handelt, sind, gleichmäßig über den Umfang verteilt, bei dem dargestellten Ausführungsbeispiel sechs solcher Verriegelungsmittel 12 vorgesehen; es versteht sich aber, daß je nach der Querschnittsform des zu befestigenden Bauelements eine beliebige Anzahl solcher Verriegelungsmittel 12 vorgesehen sein können, bei einer Viereckform beispielsweise jeweils in jeder Ecke eins, bei Rundformen drei und bei schmaleren, zu befestigenden Bauelementen gegebenenfalls auch nur zwei, dann einander gegenüberliegende Verriegelungsmittel.

Wesentlich ist, daß angrenzend zu mindestens einem, vorzugsweise zu jedem Rastbein 13 ein sogenanntes Fixierelement, welches im folgenden als Fixierbein 16 bezeichnet wird, angeordnet und im Abstand zum Rastbein 13 so positioniert ist, daß sich zwischen beiden eine in seiner Größe und seiner Ausbildung nicht kritischer Schlitz 17 ergibt, der jedenfalls sicherstellt, daß das Rastbein 13 seine und für sich gesehen auch bekannte Aufgabe erfüllen kann, nämlich unter Zurückweichen in Richtung des Pfeils A (s. Fig. 2), wobei diese Bewegung durch das Aufgleiten der vorderen Rastnasenschrägfläche 18 in der jeweils zugeordneten Durchbrechung der Print- oder Leiterplatte 20 bewirkt wird, das Einklipsen und die hierdurch sich ergebende Befestigung des Bauelements an der Leiterplatte sicherzustellen. Bei diesem Zurückweichen bewegt sich daher das Rastbein 13 kurzzeitig in Richtung auf das feststehende und im Rahmen der hier betrachteten Gegebenheiten insofern starre Fixierbein 16 und nimmt nach Durchtritt durch die Durchbrechung in der Leiterplatte 20 wieder den ursprünglichen Abstand ein, wobei dann die untere Verriegelungsfläche der Rastnase die Leiterplatte 20 hintergreift. Dies ist bekannt; wesentlich ist bei vorliegender Erfindung aber, daß das Fixierbein 16 in seiner Zuordnung zum Rastbein 13 für diese Befestigung und Verriegelung gleichzeitig zwei weitere Aufgaben übernimmt, nämlich einmal aufgrund einer Anschlagfläche 16a die Höhenfixierung des Bauelements, denn wie aus der Darstellung der Fig. 2 erkennbar, entspricht der Abstand der Anschlagfläche 16a zur unteren Verriegelungsfläche 19 der Rastnase 17 praktisch der Leiterplattendicke mit nur so viel Toleranz, daß das Rastbein sicher in seine die Verriegelung bewirkende Ausgangsposition nach dem Einklipsen gelangen kann. Hier ist ferner auch ein Ausgleich der Dickentoleranz der Trägerplatte möglich, indem der Höhenanschlag im Toleranzfeld federnd ausgebildet wird.

Ferner weist das Fixierbein 16 noch eine weitere Anschlagfläche 16b auf (s. auch Fig. 2), die, der äußeren Hauptanschlagfläche 13a des Rastbeins 13 gegenüberliegend, dafür sorgt, daß der rechteckförmige Aufnahmeausschnitt für die Verriegelungsmittel 12 insgesamt in der Leiterplatte 20 nach dem Einklipsen vollständig ausgefüllt ist, und zwar vorzugsweise noch unter einer verbleibenden Restvorspannung zwischen Rastbein 13 und Fixierbein 16, was durch entsprechende Abstandsbemessungen erzielt werden kann. Hierdurch wird sichergestellt, daß jedes Verriegelungsmittel 12 die ihm zugeordnete Durchbrechung oder Aufnahmebohrung in der Printplatte nach dem Einsetzen vollständig ausfüllt und kein Freiraum mehr verbleibt, der es dem Rastbein 13 ermöglichen würde, bei starken, aus beliebigen Richtungen, insbesondere aus Querrichtungen einwirkenden Kräften sich so in der ihn aufnehmendenDurchbrechung der Printplatte zu verschieben, daß er sich evtl. aus dieser aushängt.

Da vorzugsweise sämtliche Verriegelungsmittel 12 umlaufend bei dem betreffenden Bauteil in dieser Weise aufgebaut sind, ergibt sich schon eine sichere, spielfreie Fixierung und Aufnahme jedes einzelnen Verriegelungsmittels in der entsprechend zugeordneten Durchbrechung oder Aufnahmebohrung in der Printplatte, so daß der sichere Sitz auch dann erreicht ist, wenn keine verbleibenden Restspannungen von jeweils einandar gegenüberliegenden Rastbeinen 13, über das ganze Bauelement jeweils gesehen, vorhanden sind. Dies war bisher die einzige Möglichkeit gewesen, das stramme Anliegen der Rastbeine und damit einen sicheren Sitz des Bauelementes, soweit möglich, zu erzielen.

Damit, wie am besten der Fig. 2 entnommen werden kann, die Printplatte 20 mit ihren Durchbrechungen die Verriegelungsmittel vollständig bis zu dem vom Fixierbein 16 gebildeten Höhenanschlag 16a aufnehmen kann, und erst in dieser Endposition können ja die Rastnasen wieder nach außen drücken und die Leiterplattenrückseite hintergreifen, weisen die jeweils bis in die Leiterplattendurchbrechung eintretenden Teile des Fixierbeins 16 noch eine Anschrägung 21 auf, so daß das vollständige Einführen und Einklipsen unter allen Umständen möglich ist.

In einer weiteren vorteilhaften Ausgestaltung der Erfindung kann, wenn bei erheblicher Gewichtsbelastung durch das jeweils zu befestigende Bauelement und zu erwartenden, starken einwirkenden Vibrationen oder auch Querbeschleunigungen ein besonders verriegelungssicherer Befestigungssitz des Bauelements erreicht werden muß, noch eine zusätzliche Verriegelungsplatte 22 vorgesehen sein, die einen Außenumfang hat, der dem freien Abstand der inneren Rastbeinflächen zueinander entspricht, wenn diese sich in ihrer vollständig eingerasteten Position befinden, so daß die Verriegelungsplatte 22 dann in Richtung des Pfeils B noch von der Leiterplattenrückseite her eingesetzt und in geeigneter Weise gehalten werden kann. Dies kann dadurch geschehen, daß die Leiterplatte eine zentrale Durchtrittsbohrung 23 aufweist, die von einem vorspringenden Ansatz 22a der Verriegelungsplatte 22 durchsetzt wird, wobei dieser Ansatz seinerseits umlaufend oder nur an bestimmten Stellen über Rastnasen verfügt, so daß er selbst wieder eine Verriegelung auf der Bauelementenseite der Trägerplatte 20 findet. Hierdurch ist die Verriegelungsplatte 22 sicher gehalten, und durch die Anlage an den hinteren Rastbeinflächen ergibt sich eine absolut unverrückbare Fixierung und Verriegelung der Rastbeine in der in Fig. 2 dargestellten Verrastungsposition, die nur dann überwunden werden könnte, wenn man die Rastnasen ausbricht, also durch eine mechanische Beschädigung, jedoch nicht mehr durch beliebig einwirkende Kräfte, die lediglich Verformungen oder Verschiebungen hervorrufen könnten.

Es versteht sich, daß die Verriegelungsplatte 22 in beliebiger Weise, z.B. als Arretierscheibe, ausgebildet sein kann und auch nur an den Stellen über ihren Umfang eine Struktur aufweisen muß, an denen sie effektiv an den hinteren Flächen der Rastbeine 13 anliegt.

Eine weitere vorteilhafte Ausgestaltung vorliegender Erfindung besteht darin, daß gleichzeitig, wie bei 24 in Fig. 1 gezeigt, außen seitlich am Umfang des Trägerkörpers für das Bauelement, bei der dargestellten Ausführungsform einer Ringkerndrossel also an der unteren Halbschale 11b, von Vorsprüngen gebildete Durchführungen 25 angeformt sind, durch deren inneren Kanal eine elektrische Anschlußleitung 26 (s. Fig. 4), gegebenenfalls durch Umbiegen hindurchgeführt und bis zur Durchtrittsöffnung durch die Leiterplatte 20 in ihrer Relativposition sicher gehalten ist. Diese Durchführungen 25 ragen vorzugsweise vom Hauptlagerkörper für das Bauelement bis zur Printplattenoberfläche, so daß beim Einklipsen des gesamten Bauelements gleichzeitig auch die in diesem Fall dann abisolierten Drahtendstücke 26a der Anschlußleitungen durch die zugeordneten Bohrungen der Leiterplatte treten.

Geht man noch auf die Befestigung großer Folienkondensatoren als weiteres Ausführungsbeispiel ein, dann ergibt sich eine günstige Ausbildung, wenn man den in ein offenes Bechergehäuse eingegossenen Kondensator zur Befestigung umdreht (also mit der offenen Seite nach oben anordnet), und mit den Rastelementen versieht, die dann auch eine genaue Fixierung der Anschlußdrähte sicherstellen.

## Patentansprüche

1. Befestigungsanordnung für elektrische oder elektronische Bauelemente und Komponenten auf einer Trägerplatte, insbesondere Print- oder Leiterplatte, mit am zu befestigenden Teil Rastnasen (15) aufweisenden Verlängerungen (14), die die Trägerplattenrückseite hintergreifen, wobei räumlich angrenzend, jedoch im Abstand zu jeder ein Rastbein (13) bildenden Verlängerung (14) mit Rastnase (15) ein Fixierbein (16) angeordnet ist, welches mindestens an einer weiteren Fläche der Rastbein (13) und Fixierbein (16) aufnehmenden Trägerplattendurchbrechung anliegt, dadurch gekennzeichnet, daß das Rastbein (13) beim Einklipsen des zu befestigenden Teils in die Trägerplattendurchbrechung zuerst elastisch zurückspringt, um danach mit der Rastnase (15) die Trägerplattenrückfläche zu hintergreifen, und daß bei gleichzeitiger seitlicher Fixierung durch das Fixierbein (16) an diesem zur ergänzenden Höhenfixierung eine Höhenanschlagfläche (16a) gebildet ist, deren Abstand zur Rastnasenunterfläche (19) im wesentlichen der Dicke der Trägerplatte (20) entspricht.

2. Befestigungsanordnung nach Anspruch 1, dadurch gekennzeichnet, daß die an der weiteren Fläche der Trägerplattendurchbrechung anliegende, von dem Fixierbein (16) gebildete Anschlagfläche (16b) der von der Rastnase (15) am Rastbein (13) hintergriffenen Fläche der Durchbrechung gegenüberliegt.

3. Befestigungsanordnung nach Anspruch 1 oder 2, dadurch gekennzeichnet, daß der von einem Schlitz (17) gebildete Abstand zwischen der zugewandten Rastbeinfläche und dem Fixierbein (16) so bemessen ist, daß das Rastbein (13) beim Einklipsen in die Trägerplattendurchbrechung so weit zurücktreten kann, daß die Rastnasenunterkante bis zur Trägerplattenrückfläche durch die Durchbrechung hindurchtreten und diese hintergreifen kann, wobei der Abstand zwischen der in der Durchbrechung der Trägerplatte anliegenden Vorderfläche des Rastbeins (13) und der rückwärtigen Anschlagfläche (16b) des Fixierbeins (16) oder umgekehrt so bemessen ist, daß diese Flächen mindestens bündig, vorzugsweise unter hauptsächlich auf die Elastizität des Rastbeins (13) zurückgehender Vorspannung mit Klemmwirkung in der Trägerplattendurchbrechung sitzen.

4. Befestigungsanordnung nach einem der Ansprüche 1 bis 3, dadurch gekennzeichnet, daß der die rückwärtige Anschlagfläche (16b) des Fixierbeins (16) bildende, die Trägerplattendurchbrechung mindestens teilweise durchsetzende Vorsprung (16c) des Fixierbeins (16) eine Anschrägung (21) aufweist, zur Erleichterung des Einführens jedes aus Rastbein (13) und Fixierbein (16) bestehenden Verriegelungsmittels (12) in die zugeordnete, rechteckförmige Trägerplattendurchbrechung.

5. Befestigungsanordnung nach einem der Ansprüche 1 bis 4, dadurch gekennzeichnet, daß jedes Verriegelungsmittel (12) mit dem der Bauelementenseite zugewandten Boden des zu befestigenden Teils oder Bauelements durch einstückiges Anspritzen verbunden ist und eine Vielzahl von Arretiermittel jeweils über den Umfang des Bauelements verteilt vorgesehen sind.

6. Befestigungsanordnung nach einem der Ansprüche 1 bis 5, dadurch gekennzeichnet, daß ein das Bauelement aufnehmendes und die jeweiligen Verriegelungsmittel (12) lagerndes Gehäuseteil, z.B. eine Halbschale (10b), vorgesehen ist, an welchem von Ansätzen (24) gebildete Durchführungen (25) für elektrische Anschlußleitungen (26) vorgesehen sind.

7. Befestigungsanordnung nach Anspruch 6, dadurch gekennzeichnet, daß die Ansätze (24) mit den von ihnen gebildeten Durchführungen für die elektrischen Zuleitungen (26) bis angrenzend zur Leiterplattenoberfläche geführt sind zur präzisen Vorpositionierung zur Herstellung der elektrischen Verbindungen.

8. Befestigungsanordnung nach einem der Ansprüche 1 bis 7, dadurch gekennzeichnet, daß als zusätzliches Anschlagelement eine Verriegelungsplatte (22) vorgesehen ist, welche selbst an die den Rastnasen gegenüberliegenden Rückflächen der Rastbeine (13) anschlägt und diese hierdurch in unverrückbarer Anlage an die zugeordneten vorderen Ausschnittsflächen der Trägerplattendurchbrechung drückt.

9. Befestigungsanordnung nach Anspruch 8, dadurch gekennzeichnet, daß das die Rastbeine (13) fixierende Anschlagelement eine Arretierscheibe (22) ist mit einem äußeren Durchmesser, der dem Innendurchmesser der Rastbeine (13) im verrasteten Zustand entspricht, sowie mit Haltemitteln an der zugeordneten Leiterplatte (20).

10. Befestigungsanordnung nach Anspruch 8 oder 9, dadurch gekennzeichnet, daß die Verriegelungsplatte (22) einen eine zentrale Durchbrechung der Leiterplatte (20) durchsetzenden Ansatz (22a) aufweist, der seinerseits über Rastnasen (24) die Bauelementenseite der Printplatte (20) hintergreifend mit dieser verriegelt ist.

11. Befestigungsanordnung nach einem der Ansprüche 1 bis 10, dadurch gekennzeichnet, daß das im Gegensatz zum elastischen Rastbein starre Fixierbein eine größere Längserstreckung in Abkantrichtung des Rastbeins aufweist, derart, daß die Fixierbeine allgemein sternförmig auf den Bauelementmittelpunkt ausgerichtet sind.

12. Befestigungsanordnung nach einem der Ansprüche 1 bis 11, dadurch gekennzeichnet, daß zum Ausgleich der Dickentoleranz der Trägerplatte der Höhenanschlag (16a) im Toleranzfeld federnd ausgebildet ist.

## Claims

1. A mounting arrangement for electrical or electronic structural elements and components on a supporting board, more particularly a printed circuit or wiring board, comprising extensions (14) having engaging lugs (15) on the part to be mounted which engage behind the reverse side of the supporting board, wherein a fixing leg (16) is arranged spatially adjacent to but spaced apart from each extension (14) which together with the engaging lug (15) forms an engaging leg (13), the said fixing leg adjoining at least one further surface of the supporting board opening accommodating the engaging leg (13) and the fixing leg (16), characterised in that when the part to be mounted is clipped into the supporting board opening, the engaging leg (13) first springs back elastically so that the engaging lug (15) thereof then engages behind the reverse surface of the supporting board, and in that while lateral fixing is effected simultaneously by the fixing leg (16), there is a vertical stop surface (16a) formed thereon for the purpose of additional vertical fixing, the spacing of which from the lower surface (19) of the engaging lug essentially corresponds to the thickness of the supporting board (20).

2. A mounting arrangement according to claim 1, characterised in that the stop surface (16b) which adjoins the further surface of the supporting board opening and which is formed by the fixing leg (16) lies opposite the surface of the opening which is engaged from behind by the engaging lug (15) on the engaging leg (13).

3. A mounting arrangement according to claim 1 or 2, characterised in that the spacing, formed by a slot (17), between the facing engaging leg surface and the fixing leg (16) is of such a size that when the clip-in procedure into the supporting board opening takes place, the engaging leg (13) is able to move back far enough to enable the lower edge of the engaging lug to pass through the opening as far as the reverse surface of the supporting board and to engage behind it, the spacing between the front surface of the engaging leg (13) and the rear stop surface (16b) of the fixing leg (16) or vice versa which lie adjacently in the opening of the supporting board being of such a size that these surfaces at least fit flush in the supporting board opening with a clamping effect, preferably under initial tension which is mainly due to the elasticity of the engaging leg (13).

4. A mounting arrangement according to one of claims 1 to 3, characterised in that the projection (16c) of the fixing leg (16) forming the rear stop surface (16b) of the fixing leg (16) and at least partially passing through the supporting board opening has a chamfer (21) to facilitate the insertion of each locking means (12) composed of engaging leg (13) and fixing leg (16) into the associated rectangular supporting board opening.

5. A mounting arrangement according to one of claims 1 to 4, characterised in that each locking means (12) is connected by injection-moulding in one piece to the base, facing the component side, of the part or component to be mounted, and a plurality of retaining means are provided, respectively distributed over the periphery of the component.

6. A mounting arrangement according to one of claims 1 to 5, characterised in that a housing part is provided, e.g. a half shell (10b), which holds the component and carries the respective locking means (12), on which housing part there are provided bushings (25) formed by attachments (24) for electrical connection leads (26).

7. A mounting arrangement according to claim 6, characterised in that the attachments (24) with the bushings formed thereby for the electrical supply leads (26) are guided until they are contiguous with the surface of the wiring board for exact pre-positioning so as to produce the electrical connections.

8. A mounting arrangement according to one of claims 1 to 7, characterised in that a locking plate (22) is provided as an additional stop element which itself abuts the rear surfaces of the engaging legs (13) lying opposite the engaging lugs, and which thereby presses them into immovable abutment against the associated front cutaway surfaces of the supporting board opening.

9. A mounting arrangement according to claim 8, characterised in that the stop element which fixes the engaging legs (13) in position is a retaining plate (22) with an external diameter corresponding to the internal diameter of the engaging legs (13) in the engaged state and comprising holding means on the associated wiring board (20).

10. A mounting arrangement according to claim 8 or 9, characterised in that the locking plate (22) has an attachment (22a) which passes through a central opening through the wiring board (20) and which is itself locked with the printed circuit board (20) by way of engaging lugs (24), engaging behind the component side of the said printed circuit board.

11. A mounting arrangement according to one of claims 1 to 10, characterised in that the fixing leg, which unlike the elastic engaging leg is rigid, has a greater longitudinal extent in the direction of the chamfer of the engaging leg, so that the fixing legs are generally aligned radially in relation to the centre point of the component.

12. A mounting arrangement according to one of claims 1 to 11, characterised in that in order to compensate the thickness tolerance of the supporting board, the vertical stop (16a) is designed to be flexible within the tolerance zone.

## Revendications

1. Système de fixation d'éléments ou composants électriques ou électroniques sur une plaque support, en particulier une platine conductrice ou à circuit imprimé, dans lequel l'élément à fixer est équipé d'appendices (14) portant les dents d'accrochage (15) venant en prise sur la face arrière de la plaque support, tandis qu'au voisinage mais à une certaine distance de chaque appendice (14) constituant une patte d'arrêt (13), est disposée une patte de fixation (16) reposant au moins sur une autre partie de l'ouverture de la plaque support recevant la patte d'arrêt (13) et la patte de fixation (16), caractérisé en ce que la patte d'arrêt (13) lorsqu'on engage, pour le serrer, l'élément à fixer dans l'ouverture de la plaque support, commence par reculer élastiquement pour pouvoir ensuite venir en prise par sa dent d'accrochage (15) sur la face arrière de la plaque support, tandis que pour assurer simultanément une fixation latérale au moyen de la patte de fixation (16), il est prévu sur cette patte une surface de butée de profil (16a) déterminant la hauteur à obtenir, la distance entre cette surface (16a) et la surface d'accrochage (19) de la dent (15) étant sensiblement égale à l'épaisseur de la plaque support.

2. Système de fixation selon la revendication 1, caractérisé en ce que la surface de butée (16a) portée par la patte de fixation (16) et reposant sur l'autre partie de l'ouverture de la plaque support fait face à la partie de l'ouverture sur laquelle est en prise la dent d'accrochage (15) de la patte d'arrêt (13).

3. Système de fixation selon la revendication 1 ou 2, caractérisé en ce que la distance séparant sous la forme d'une encoche (17) la face de patte d'arrêt et la patte de fixation est dimensionnée de manière que, lors du serrage, dans l'ouverture de la plaque support, la patte d'arrêt (13) puisse reculer suffisamment pour que la face d'accrochage de la dent puisse passer à travers l'ouverture de la plaque et venir en prise derrière celle-ci, la distance entre la surface antérieure de la patte d'arrêt (13) en appui dans l'ouverture de la plaque et la surface de butée (16b), orientée vers l'arrière de la patte de fixation (16) étant dimensionnée de manière à ce que ces surfaces se trouvent obligatoirement, de préférence sous l'effet de rappel résultant de l'élasticité de la patte d'arrêt (13), logées avec serrage dans l'ouverture de la plaque support.

4. Système de fixation selon l'une des revendications 1 à 3, caractérisé en ce que la saillie (16c) de la patte de fixation (16) qui porte la surface de butée arrière (16b) de la patte (16) et qui traverse au moins partiellement l'ouverture de la plaque support, présente une partie oblique (21) facilitant l'introduction dans l'ouverture rectangulaire correspondante de la plaque support, de chacun des ensembles de verrouillage (12) constitués par une patte d'arrêt (13) et une patte de fixation (16).

5. Système de fixation selon une des revendications 1 à 4, caractérisé en ce que chaque ensemble de verrouillage (12) est réalisé solidaire du fond de la pièce ou de l'élément à fixer, par injection monobloc, un certain nombre de moyens d'arrêt étant répartis à la périphérie de l'élément.

6. Système de fixation selon une des revendications 1 à 5, caractérisé en ce qu'il est prévu une partie de boîtier, par exemple une demicuvette (10b), servant de logement à l'élément à fixer et aux divers ensembles de verrouillage (12) et munie de passages (25) en forme d'appendices (24) pour recevoir les raccords électriques (26).

7. Système de fixation selon la revendication 6, caractérisé en ce que les appendices (24) servant de passage aux raccords électriques (26) s'étendent jusqu'à la limite de la face supérieure de la plaque conductrice, assurant ainsi un prépositionnement précis pour la réalisation des liaisons électriques.

8. Système de fixation selon une des revendications 1 à 7, caractérisé en ce qu'une butée supplémentaire est prévue sous la forme d'une platine de verrouillage (22) qui vient, elle-même s'appuyer en butée sur les faces arrière, opposées aux dents d'accrochage, des pattes d'arrêt (13), en poussant celles-ci en position irréversible contre les parois antérieures correspondantes de la découpe constituant l'ouverture du panneau support.

9. Système de fixation selon la revendication 8, caractérisé en ce que l'élément de butée fixant les pattes d'arrêt (13) est constitué d'un disque d'arrêt (22) de diamètre extérieur correspondant au diamètre intérieur des pattes d'arrêt (13) en position bloquée, ainsi que d'organes de maintien portés par la plaque conductrice (20) correspondante.

10. Système de fixation selon la revendication 8 ou 9, caractérisé en ce que la plaque de verrouillage (22) est équipée d'un nez (22a) passant à travers une ouverture centrale de la plaque conductrice (20) et qui, au moyen de dents d'accrochage (24) en prise avec la face, côté élément à fixer, de la plaque conductrice (20) se trouve verrouillée sur cette plaque.

11. Système de fixation selon une des revendications 1 à 10, caractérisé en ce que la patte de fixation rigide, par rapport à la patte d'arrêt élastique, présente selon la direction du chanfrein de la patte d'arrêt, une dimension supérieure de sorte que les pattes de fixation se trouvent disposées en étoile par rapport au centre de l'élément à fixer.

12. Système de fixation selon une des revendications 1 à 11, caractérisé en ce que, pour compenser les tolérances d'épaisseur de la plaque support, la butée de profil (16a) présente une élasticité couvrant la plage de tolérance.
